Europäisches Patentamt

European Patent Office

Office européen des brevets

(11) Publication number: **0 190 934 B1**

# EUROPEAN PATENT SPECIFICATION

(45) Date of publication of patent specification: **15.01.92**

(51) Int. Cl.⁵: **H01L 21/18**, H01L 29/74, H01L 21/306, H01L 29/10

(21) Application number: **86300819.9**

(22) Date of filing: **06.02.86**

(54) **Method of manufacturing a thyristor.**

(30) Priority: **08.02.85 JP 22940/85**

(43) Date of publication of application:
**13.08.86 Bulletin 86/33**

(45) Publication of the grant of the patent:
**15.01.92 Bulletin 92/03**

(84) Designated Contracting States:
**DE GB SE**

(56) References cited:
**EP-A- 0 136 050**
**EP-A- 0 190 935**
**DE-A- 3 037 316**
**FR-A- 2 394 175**

(73) Proprietor: **KABUSHIKI KAISHA TOSHIBA**
**72, Horikawa-cho Saiwai-ku**
**Kawasaki-shi Kanagawa-ken 210(JP)**

(72) Inventor: **Ogura, Tsuneo c/o Patent Division**
**Kabushiki Kaisha Toshiba 1-1 Shibaura**
**1-chome**
**Minato-ku Tokyo 105(JP)**
Inventor: **Ohashi, Hiromichi c/o Patent Division**
**Kabushiki Kaisha Toshiba 1-1 Shibaura**
**1-chome**
**Minato-ku Tokyo 105(JP)**
Inventor: **Nakagawa, Akio c/o Patent Division**
**Kabushiki Kaisha Toshiba 1-1 Shibaura**
**1-chome**
**Minato-ku Tokyo 105(JP)**
Inventor: **Shimbo, Masaru c/o Patent Division**
**Kabushiki Kaisha Toshiba 1-1 Shibaura**
**1-chome**
**Minato-ku Tokyo 105(JP)**

(74) Representative: **Freed, Arthur Woolf et al**
**MARKS & CLERK 57-60 Lincoln's Inn Fields**
**London WC2A 3LS(GB)**

## Description

The present invention relates to a method of manufacturing a thyristor and, more particularly, to a method of manufacturing a gate turn-off (GTO) thyristor.

Conventional GTO thyristors do not require a commutating circuit since they can be turned on and off by applying a positive or negative bias to the gate electrode. Due to their short switching time, GTO thyristors are capable of high frequency operation.

In GTO thyristors, however, thermal breakdown occurs when the power loss during turn-off reaches a certain value. This is because local current crowding occurs in GTO thyristors during turn-off. As a result, the anode current flow must be kept under about 2,000 A, making the current capacity of GTO thyristors lower than that of a normal thyristor.

In order to resolve this problem, GTO thyristors generally use a multi-emitter structure. In a multi-emitter structure, the cathode region is divided and a plurality of small GTO elements are connected in parallel to the divided portions. By using such a structure the current crowding in a region of the GTO can be attenuated through dispersion and current capacity can thus be increased somewhat.

Even with this improvement, however, current crowding still occurs to a certain extent in each GTO element, such that the problem is not significantly resolved. More specifically, the balance of the anode current flowing between the GTO elements is lost during turn-off, current crowding occurs in one or more of the GTO elements, and, in the end, breakdown occurs. One of the causes of this is as follows. In present thyristor manufacturing techniques, it is difficult to obtain a uniform carrier lifetime when diffusion is performed over the entire surface of a wafer having a diameter of 20 - 40 mm or more. Another cause is the unsatisfactory turn-off breakdown properties of the respective GTO elements.

In order to resolve this problem, a method of increasing the breakdown voltage of the junction between an n-type emitter layer and a p-type base layer by reducing the sheet resistance of the p-type base layer has been proposed (Japanese Patent Disclosure No. 53-110386). Towards the same end, a method of giving a p-type base layer a low sheet resistance and a uniform impurity concentration by using an epitaxial growth method has also been proposed (Japanese Patent Disclosure No. 52-102687).

Examination of both of these proposed methods, however, reveals that neither is satisfactory in resolving the problem inherent in GTO thyristors. Whereas sufficient reduction in the sheet resistance of the p-type base layer is contingent upon a base layer thickness of at least 30 $\mu$m, obtaining a sufficiently high injection efficiency for the n-type emitter layer formed by diffusion in the p-type base layer necessitates that the former be formed to a thickness of at least 20 $\mu$m. Consequently, when the p-type base layer is formed using an epitaxial growth method, the epitaxial layer must be at least 50 $\mu$m in thickness. However, since epitaxial growth methods require high temperatures of about 1200 $^\circ$C, numerous defects are formed in the n-type base layer (i.e., the substrate), carrier lifetime is shortened, and the ON voltage of the GTO thyristor is increased. Finally, when an extremely thick epitaxial layer of more than 40 um is formed, numerous defects are also formed in the grown layer, the lifetime of the carriers in the p-type base layer is shortened, and the ON voltage of the GTO thyristor is thus increased.

It is an object of the present invention to provide a method of manufacturing a thyristor having a long carrier lifetime and a high turn-off breakdown current, without using an epitaxial method.

Copending European application EP-A-0190935 discloses a method for manufacturing semiconductor devices by bonding a first doped semiconductor wafer having an impurity doped layer on a major surface to a second semiconductor wafer which also has an impurity doped layer on a major surface. In this method, both said major surfaces are mirror polished with a roughness less than 50nm, placed in contact with each other, and annealed at a temperature of not less than 200 $^\circ$C. It is a further requirement of the method that both said surface impurity layers are of the same conductivity type and have a higher doping concentration than that of said first semiconductor wafer.

According to the present invention, there is provided a method of manufacturing a thyristor according to Claim 1.

The base layer produced as above may be a p-type base layer and/or a low resistance n-type base layer. With the method of the present invention, after the first and second semiconductor substrates are bonded together, one or both surfaces of the substrates may be polished to adjust the thickness of the resultant structure. P- and n-type emitter layers may then be formed.

For the purposes of polishing, an optical polishing method such as a mirror polishing method can be adopted. As indicated in Claim 1, the roughness of polished surfaces should be 50 nm or less. It should be noted that "surface roughness" is given by a maximum (Rmax) as defined in JISB-0601 (1982).

Once polished, surfaces should preferably be washed with water, surfactant, organic solvent, acid solution, or the like in order to remove contaminants such as fine particles, absorbed ions, organic material, inorganic material, and the like. A room whose environment contains no more than 20 particles/m$^3$ of foreign substances is considered clean enough to allow for the desired particulate-free contact and subsequent bonding of the polished and washed surfaces. The annealing temperature should, preferably, fall within the range of 600 to 1200°C.

Unlike when forming a low resistance base layer by means of an epitaxial method, a pnpn wafer, using the present invention, can easily be obtained without using a lengthy annealing process. Furthermore, since the carrier lifetime of p-type and n-type base layers can be prolonged sufficiently, a thyristor (a GTO thyristor) having a low ON voltage and a high turn-off breakdown current can be realized.

This invention can be more fully understood from the following detailed description, by way of example only, of preferred embodiments, when taken in conjunction with the accompanying drawings, in which:

Figs. 1A to 1D are sectional views showing steps in the manufacture of the thyristor in Example 1 of the present invention;

Fig. 2A is a graph showing the relationship between an annealing temperature and the sheet resistance of a p-type portion after bonding;

Fig. 2B is a graph showing the impurity concentration distribution of the thyristor obtained in Example 1;

Figs. 3 and 4 are graphs comparing the characteristics of the thyristor obtained in Example 1 with those of a conventional thyristor;

Figs. 5A to 5C are sectional views showing steps in the manufacture of the thyristor in Example 2 of the present invention;

Fig. 6 is a graph showing the impurity concentration distribution of the thyristor obtained in Example 2;

Fig. 7 is a graph showing the impurity concentration distribution of the thyristor obtained in Example 3;

Fig. 8 is a graph showing the impurity concentration distribution of the thyristor obtained in Example 4;

Fig. 9 is a graph showing the impurity concentration distribution of the thyristor obtained in Example 5;

Figs. 10A to 10C are sectional views showing steps in the manufacture of the thyristor in Example 6 of the present invention;

Fig. 11 is a graph showing the impurity concentration distribution of the thyristor obtained in Example 6;

Fig. 12 is a graph showing the impurity concentration distribution of the thyristor obtained in Example 7;

Fig. 13 is a sectional view of the thyristor obtained in Example 8;

Figs. 14A and 14B are sectional views showing steps in the manufacture of the thyristor in Example 9;

Fig. 15 is a graph showing the impurity concentration distribution of the thyristor obtained in Example 9; and

Fig. 16 is a graph showing the impurity concentration distribution of the thyristor obtained in Example 10.

The present invention will be described by way of examples and with reference to the accompanying drawings.

Example 1

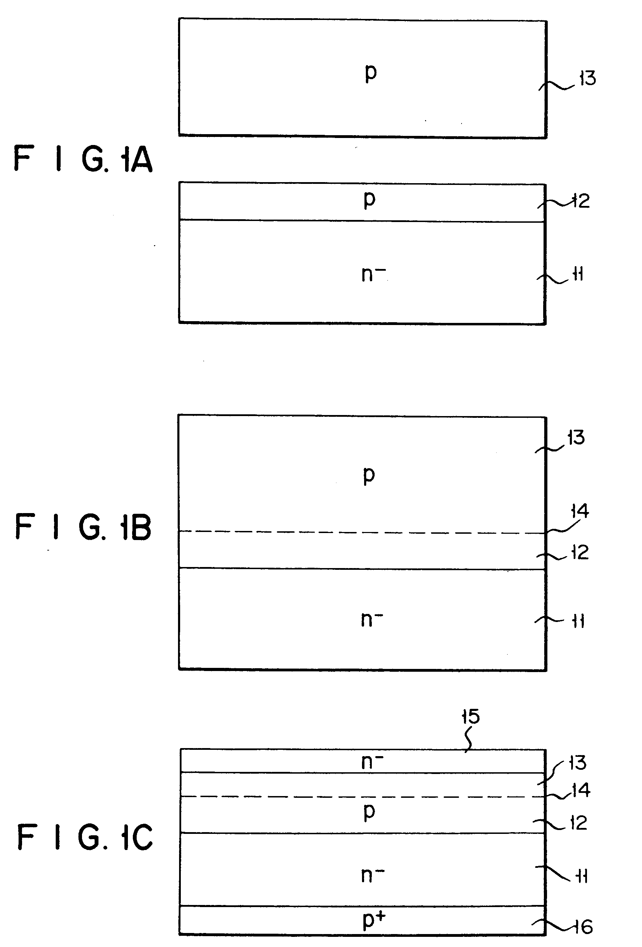

Figs. 1A to 1D show steps in the manufacture of the GTO thyristor in Example 1. As shown in Fig. 1A, p-type layer 12, as a portion of a low resistance p-type base layer, is formed on the surface of n⁻-type Si substrate (first semiconductor substrate) 11 as a high resistance n-type base layer. P-type Si substrate (second semiconductor substrate) 13 is prepared and constitutes the remaining portion of the p-type base layer. Substrate 13 has an impurity concentration of $10^{17}$ to $10^{18}$/cm$^3$. The surfaces of the two substrates are, prior to bonding, mirror polished to provide a surface roughness of 500 Å or less. P-type layer 12, formed on the surface of substrate 11, can be obtained by boron or gallium diffusion, and has, preferably, a diffusion width of 10 to 30 $\mu$m and a surface concentration of $10^{18}$/cm$^3$ or more. The substrates are then subjected to pretreatment using a solution mixture of $H_2O_2$ + $H_2SO_4$, an HF solution, and a dilute HF solution in that order to remove grease and stain films. The substrates are washed with purified water for several minutes and are then spindried at room temperature. This last step removes only excess water and not that adsorbed in the mirror polished surfaces of the substrates. Therefore, the substrate must not be heated to a temperature of 100°C or higher, at which almost all of the adsorbed water would vaporize.

Substrates 11 and 13, obtained through the above procedures, are placed into a pure atmosphere of, for example, Class 1 or below, and their polished surfaces are brought into contact with each other, as shown in Fig. 1B, such that no foreign substances lie therebetween. The substrates are annealed at a temperature of 200°C or higher to produce a bonded substrate with enhanced adhesive strength. Bonding interface 14 exhibits characteristics of good ohmic contact.

The thickness of substrate 11 is determined by that of the high resistance n-type base layer. For example, when an element having a breakdown voltage of 4.5 kV is used, the thickness of substrate 11 should be about 700 to 800 $\mu$m. The thickness of substrate 13 should be 300 $\mu$m or more in consideration of the above bonding procedure.

The substrate 13 side of the resultant substrate is polished to obtain a 50 $\mu$m thick p-type layer. Phosphorus or the like is then doped into the polished surface to form 20 $\mu$m thick, $n^+$-type emitter layer 15. $P^+$-type emitter layer 16 is formed on the back surface of substrate 11. $P^+$-type emitter layer 16 can also be formed before the substrates are bonded together. In this way, a pnpn wafer which will serve as the basic structure of a thyristor can be obtained.

As shown in Fig. 1D, $n^+$-type emitter layer 15 is divided into a plurality of portions by a known selective etching method. Cathode electrode 17, gate electrode 18, anode electrode 19, and protective film 20 are then formed on respective portions of divided layer 15, thus preparing a GTO thyristor.

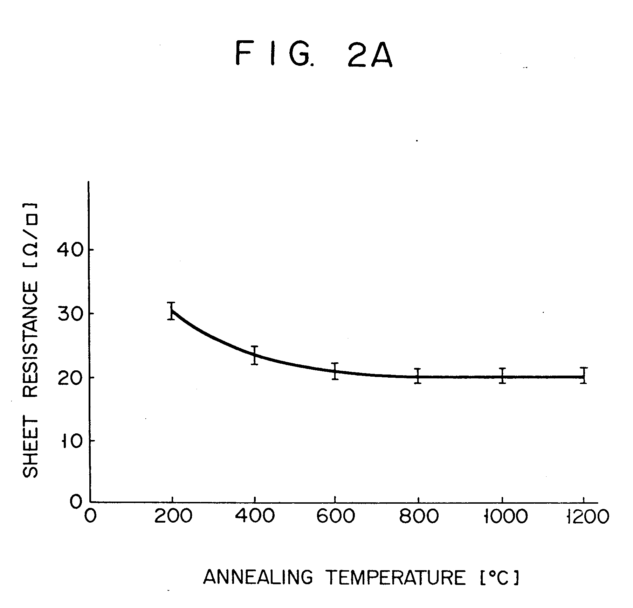

Fig. 2A shows the relationship between an annealing temperature, annealing being performed to improve the bonding strength, and the sheet resistance of a p-type portion after bonding (Fig. 1B). The sheet resistances of p-type layers 12 and 13, as measured by a four-point probe-method, are 40 $\Omega$/□. As shown in Fig. 2A, it is desired that the substrates be thermally annealed, for purposes of bonding, at temperatures of from 600 to 1200°C.

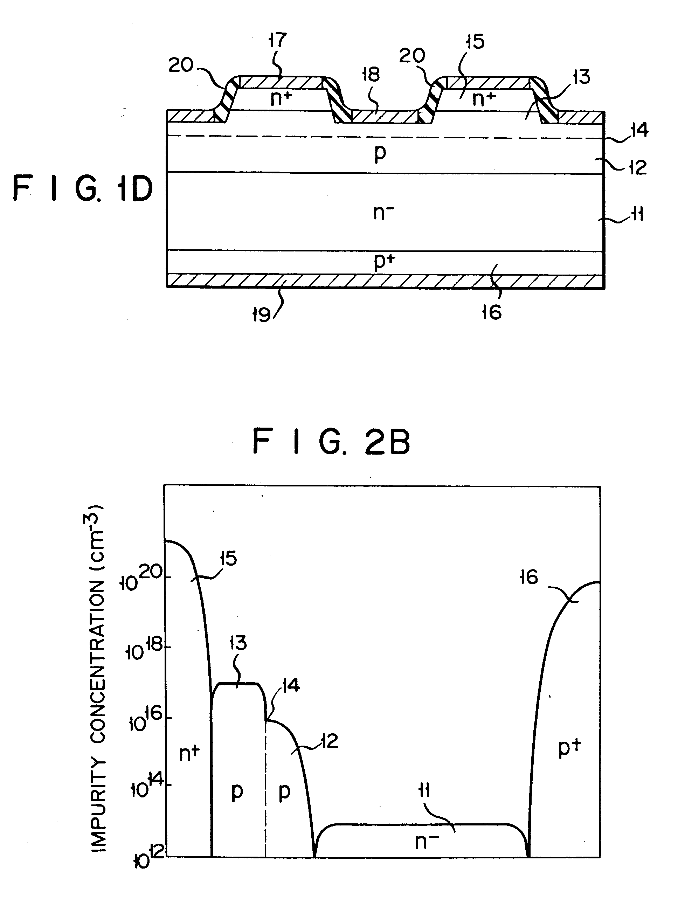

Fig. 2B shows the impurity concentration distribution of the GTO thyristor obtained in this example. The GTO thyristor of this example has a higher maximum turnoff current and a lower ON voltage than a conventional thyristor. A GTO thyristor with a breakdown voltage of 4.5 kV was manufactured in order to compare its characteristics with those of a conventional thyristor.

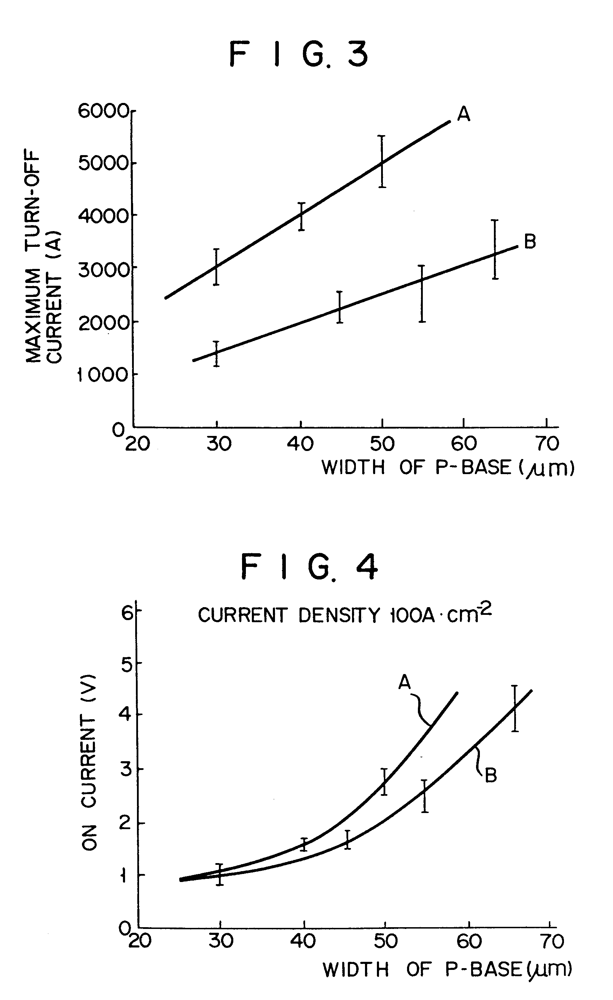

Fig. 3 is a graph comparing the maximum turn-off currents of the GTO thyristor obtained in this example, with those of a conventional GTO thyristor. In Fig. 3, line A indicates data for the GTO thyristor of this example, and line B indicates data for a conventional GTO thyristor in which the p-type base layer is formed by diffusion. As is well known, maximum turn-off current is inversely proportional to the sheet resistance of the p-type base layer. As indicated by line B, in the conventional thyristor, even if the width of the p-type base layer is increased, the sheet resistance cannot easily be reduced. This is because the impurity concentration distribution is, due to diffusion, represented by a complementary error function. In contrast to this, the maximum turn-off current in the thyristor of this example can easily be increased since its sheet resistance is inversely proportional to the width of the p-type base layer. In this example, assuming that the thickness of p-type layer 12, formed by diffusion at the side of substrate 11, is 20 $\mu$m and that the concentration of substrate 13 is 5 × $10^{15}$/cm$^3$, the p-type base layer exhibits a total charge amount of 1 × $10^{13}$/cm$^3$ and a sheet resistance of about 20 $\Omega$/□. At this time, as shown in Fig. 3, the maximum turn-off current is about 4,000 A. In the conventional thyristor, however, when the width of the p-type base layer is 55 $\mu$m, its sheet resistance is about 50 $\Omega$/□ and its maximum turn-off current is about 2,500 A.

Fig. 4 shows the results of a comparison of ON voltages when the current density is 100 A/cm$^2$. As is well known, ON voltage depends on the width, the impurity concentration and the carrier lifetime of the p-type base layer. As shown in Fig. 4, although ON voltages (curves A and B) increase upon an increase in width of the p-type base layer, curve A (this example) becomes slightly steeper than curve B (the conventional thyristor) because of the weaker drift effect of electrons injected into the p-type base layer of the thyristor of this example. The GTO thyristor of this example, having a breakdown voltage of 4.5 kV, can provide a maximum turn-off current of 4,000 A and an ON voltage of 1.5 V, whereas the conventional thyristor, having a p-type base layer width of 55 $\mu$m, provides a maximum turn-off current of 2,500 A and an ON voltage of 2.5 V. According to this example, then, the maximum turn-off voltage can be notably increased and the ON voltage reduced.

In the conventional method of forming a p-type base layer by an epitaxial growth method, the ON voltage is increased undesirably when a thick p-type base layer is formed. For example, when the width of the p-type base layer is about 30 $\mu$m, the ON voltage is about 2.0 V. The thyristor of this example is thus superior to a conventional one.

Example 2

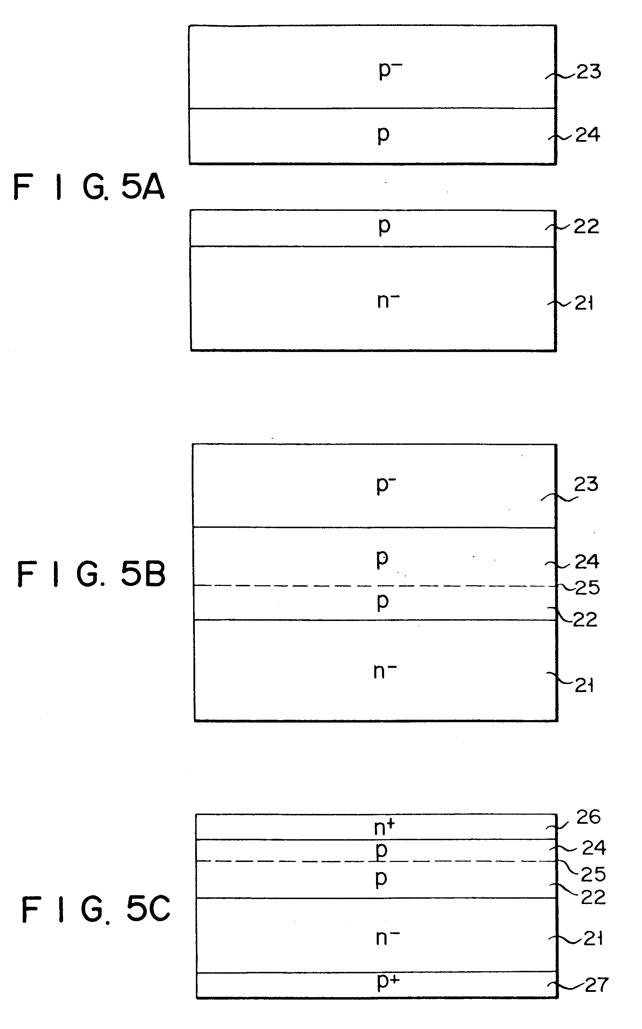

Figs. 5A to 5C show steps in the manufacture of the GTO thyristor in Example 2. As shown in Fig. 5A, p-type layer 22, as a part of a p-type base layer, is formed on a polished surface of $n^-$-type Si substrate (first semiconductor substrate) 21 as a high resistance n-type base layer whose surface is mirror polished. In addition, p-type layer 24, constituting the remaining portion of the p-type base layer, is formed by diffusion on a mirror polished surface of $p^-$-type Si substrate (second semiconductor substrate) 23. As shown in Fig. 5B, the mirror polished surfaces of the substrates were subjected to purification and subsequently bonded, in the same manner and under the same conditions as in Example 1. Substrate 23 need only have a higher resistance than p-type layer 24, or can be of an n-type. The surface of the resultant substrate at the side of substrate 23 is polished to a predetermined thickness. $N^+$-type emitter layer 26 and $p^+$-type emitter layer 27, shown in Fig. 5C are then formed by impurity diffusion in the polished surface. As in Example 1, $p^+$-type emitter layer 27 can be formed before the substrates are bonded together. A GTO thyristor is obtained using the thus formed pnpn wafer as its basic structure in the same manner as in Example 1.

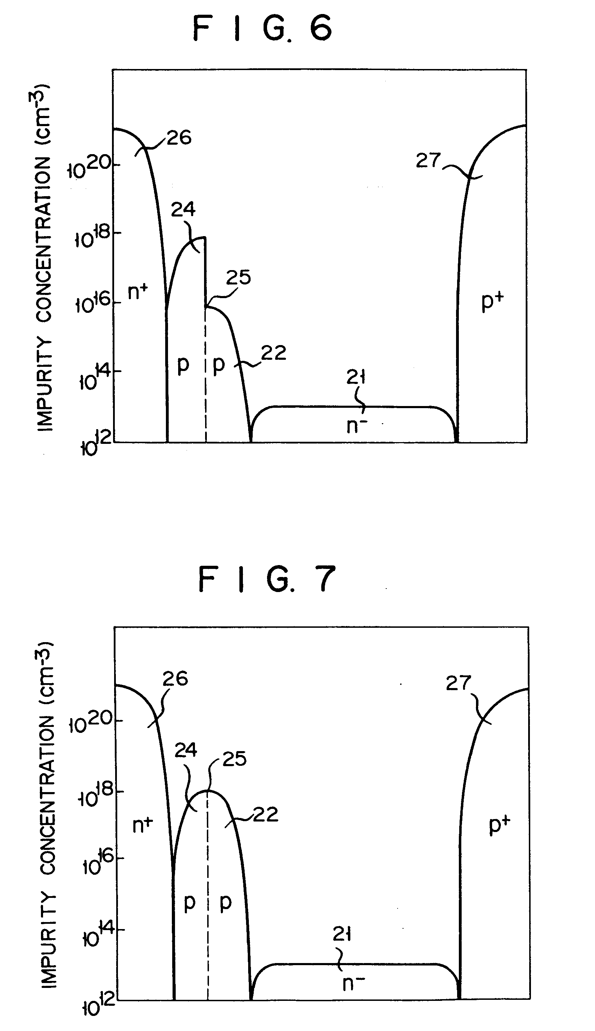

Fig. 6 shows the impurity concentration distribution of the GTO thyristor obtained in Example 2. The same effects as in Example 1 can be obtained in Example 2. As can be seen from Fig. 6, in Example 2, since the sheet resistance of the p-type base layer can be controlled by the impurity concentration of the diffusion layers at the two sides of bonding interface 25, control of the sheet resistance of the p-type base layer is improved over that of the thyristor of Example 1.

Example 3

In Examples 1 and 2, the impurity concentrations at either side of bonding interface 25 differ. As shown in Fig. 7, however, impurity concentrations at either side of interface 25 can be made equal. This is advantageous when two p-type layers are utilized in order to reduce the sheet resistance of the p-type base layer.

Example 4

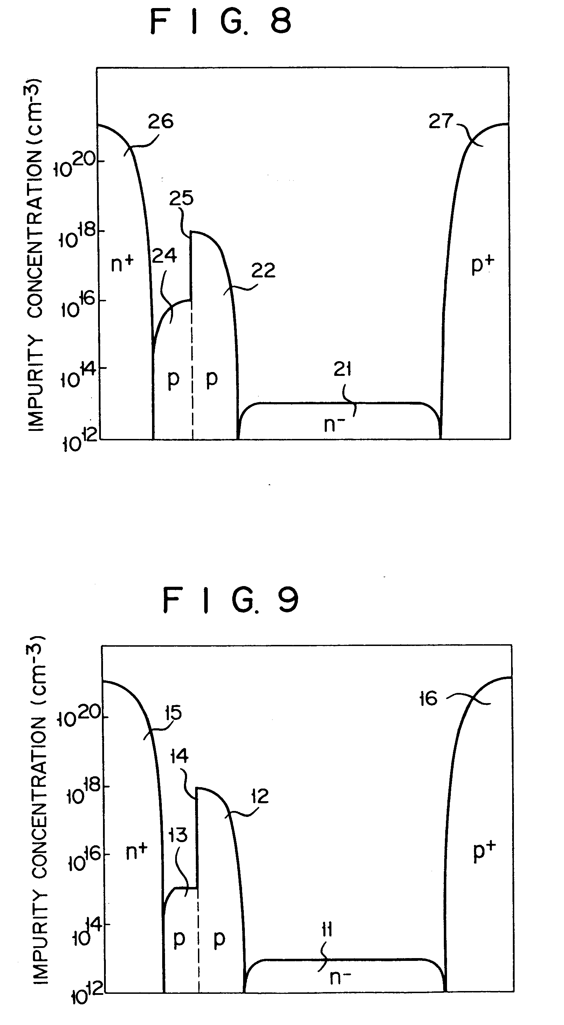

In Fig. 8, the relationship between the impurity concentrations of p-type layers 22 and 24 is reversed to that shown in Fig. 6. A structure wherein p-type layers have this relationship is proposed in order to reduce the sheet resistance of the p-type base layer by using p-type layer 22 at the side of the n-type base layer. This structure can easily suppress the high concentration impurity doping effect which is a major cause of inefficiency in electron injection from the n-type emitter layer. Thus, the ON voltage can be decreased. A high impurity concentration layer portion of the p-type base layer can be formed by ion-implantation at a concentration of $10^{15}$ to $10^{16}$/cm$^3$, and subsequent thermal diffusion at a temperature of 1,000 to 1,250°C for 10 to 50 hours.

Example 5

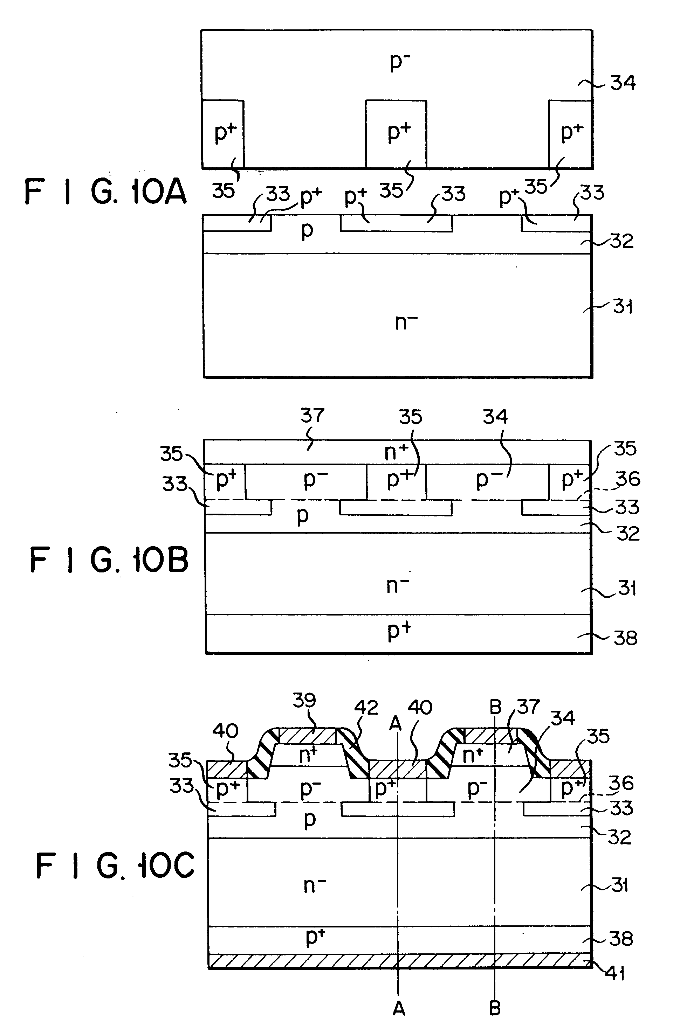

Fig. 9 shows the impurity concentration distribution when the same impurity concentration distribution as in Example 4, shown in Fig. 8, is achieved by the method of Example 1, shown in Figs. 1A to 1D.

Example 6

In Examples 1 to 5, the horizontal impurity concentration distribution in the p-type base layer is uniform. The present invention, however, is also effective when the horizontal impurity distribution varies in the p-type base layer.

Figs. 10A to 10C show steps in the manufacture of the GTO thyristor of this example. As shown in Fig. 10A, p-type layer 32, as a portion of the p-type base layer, is formed on the mirror polished surface of $n^-$-type Si substrate (first semiconductor substrate) 31 as a high resistance n-type base layer. $P^+$-type layers 33 are then selectively formed on the gate region of the surface of layer 32. $P^+$-type layers 35 are selectively formed on the gate region of the polished surface of $p^-$-type Si substrate (second semiconductor substrate) 34 and constitute the remaining portion of the p-type base layer. These substrates are bonded together in the same manner as in the above examples, and the thickness of the resultant structure, shown in Fig. 10B, is controlled. Then, $n^+$-type emitter layer 37 and $p^+$-type emitter layer 38 are formed on the structure. $P^+$-type emitter layer 38 can also be formed before the substrates are bonded together. The structure is mesa etched so as to form cathode electrode 39, gate electrode 40, anode electrode 41, and protective film 42, as shown in Fig. 10C, thus completing the GTO thyristor.

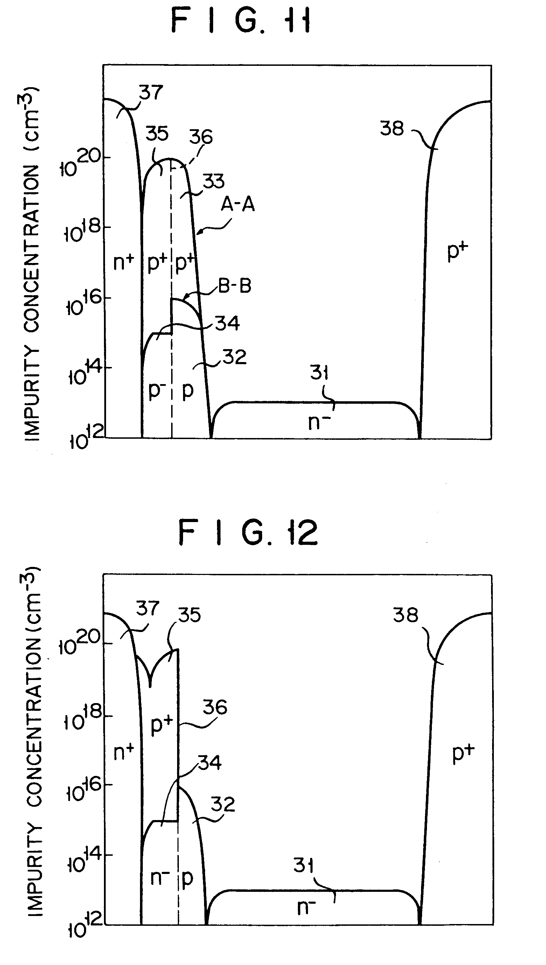

Fig. 11 shows, in cross-sectional views taken along lines A - A and B - B in Fig. 10C, the impurity concentration distribution of the GTO thyristor obtained in Example 6.

The GTO thyristor of this example has a small ON voltage due to the small total charge amount of the p-type base layer in a conductive portion under cathode electrode 39. In addition, since the p-type base layer under gate electrode 40 comprises $p^+$-type layers 33 and 35, the total charge amount thereof is large, and the maximum turn-off current increases.

Example 7

Fig. 12 shows the impurity concentration distribution to correspond with Fig. 11 when the position of interface 36 is slightly shifted from that in Example 6, and, more specifically, when $p^+$-type layer 33, at, as shown in Fig. 10A, the side of substrate 31, is formed at the side of substrate 34, and the junction between layers 33 and 32 is used as a bonding interface. In this example, the same effect as in the above examples can be obtained.

Example 8

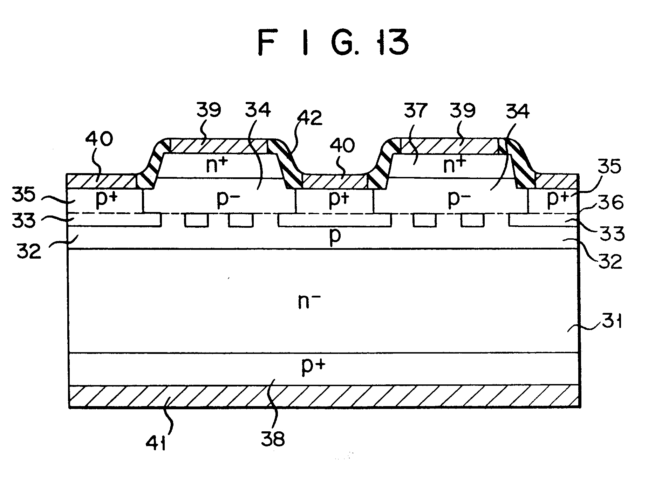

Fig. 13 shows a slightly modified version of the Example 6 GTO thyristor shown in Figs. 10A through 10C. In this example, $p^+$-type layers 33 are arranged in grid form not only on the gate region but also in a region under the cathode electrode, as can be seen from a comparison with Fig. 10C. This structure is useful in shutting off the current during turn-off.

Example 9

In the above examples, the bonding interface is located in the p-type base layer. The present invention, however, is not limited to this arrangement. For example, a GTO thyristor with a structure in which a low resistance n-type base layer (buffer layer) is provided at the side of the p-type emitter layer of a high resistance n-type base layer has been proposed. This structure can be adopted in order to reduce the width of the n-type base layer and thereby to reduce the ON voltage by suppressing extension of a depletion layer in a normal breakdown state at the cost of reverse breakdown voltage, and to shorten the turn-off period by controlling holes injected from the p-type emitter layer during turn-on. According to the present invention, when this structure is adopted, the substrate connection interface can also be located in the low resistance n-type base layer.

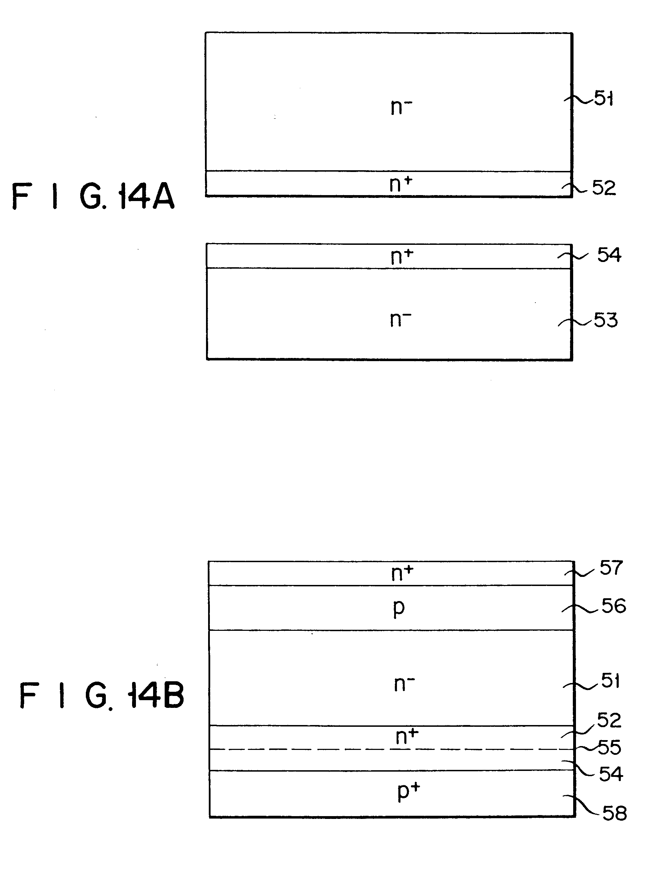

Figs. 14A and 14B show steps in the manufacture of the GTO thyristor of Example 9. As shown in Fig. 14A, $n^+$-type layer 52, as a first portion of a low resistance n-type base layer, is formed on the mirror polished surface of $n^-$-type Si substrate (first semiconductor substrate) 51 as a high resistance n-type base layer. $N^+$-type layer 54, constituting the second portion of the low resistance n-type base layer, is formed on the mirror polished surface of $n^-$-type Si substrate (second semiconductor substrate) 53. These substrates are bonded together in the same manner as in the above examples, and the thickness of the resultant structure is controlled as required. P-type base layer 56 is formed on the resultant structure by diffusion, and $n^+$-type emitter layer 57 and $p^+$-type emitter layer 58 are formed thereon, thus obtaining a pnpn wafer. Thereafter, the GTO thyristor is completed through normal procedures.

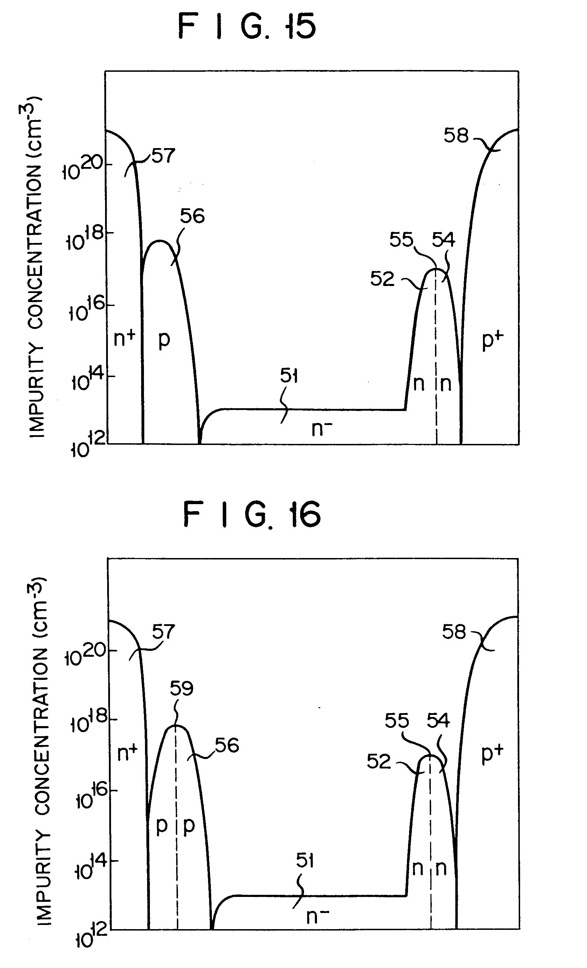

Fig. 15 shows the impurity concentration distribution of the GTO thyristor obtained in Example 9.

With the method of this example, a GTO thyristor with excellent characteristics can easily be obtained when compared with the product of the conventional method which uses an epitaxial method.

Example 10

Fig. 16 shows the impurity concentration distribution of a GTO thyristor in which bonding interface 59 is also provided in the p-type base layer, to correspond with that shown in Fig. 15. In this example, the same GTO thyristor as in Example 8 is produced using three substrates.

The relationship between turn-off gain $\beta^*$ of the GTO thyristor and current amplification factors αnpn and αpnp when the pnpn structure of the GTO thyristor is represented by pnp and npn transistors is as follows:

$$\beta^* = \alpha npn/(\alpha npn + \alpha pnp - 1)$$

When turn-off gain $\beta^*$ is increased, gate current during turn-off can be decreased so as to control a large current. For this purpose, factor αnpn must be increased. In the conventional method, a single substrate is formed on a pnpn wafer using an epitaxial method and a diffusion technique, and a heavy metal (e.g., gold) is then diffused at a temperature of 800°C or higher in order to accelerate attenuation of carriers in the n-type base layer during turn-off. As a result, however, the lifetimes of the n-type base layer and the p-type base layer are shortened, and factor αnpn is unpreferably decreased.

According to the method of the present invention, even if a heavy metal (e.g., gold) is diffused at the side of the n-type base layer, or an electron beam or the like is radiated onto the n-type base layer before the substrates are bonded together, though the lifetime of the n-type base layer will be reduced, that of the p-type base layer will not be. Therefore, a large factor αnpn can be mainatined and a GTO thyristor with large turn-off gain $\beta^*$ obtained. In this case, it is preferable that the electron beams be radiated sufficiently to provide a sufficient radiation effect even after the time killer is extinguished during the subsequent annealing step.

Though in Examples 1 to 9, the manufacture of GTO thyristors has been explained, the present invention can also be applied to the manufacture of various other thyristors, for example, reverse conduction thyristors, optical thyristors, and the like.

**Claims**

1. A method of manufacturing a thyristor having a base layer comprising first and second impurity layers which are bonded to each other, comprising the steps of:

bringing, in an atmosphere virtually free of particulate matter, a first semiconductor substrate (11) having on a major surface thereof a first impurity layer (12) whose surface is mirror polished with a roughness of not more than 50 nm into contact with a second semiconductor substrate (13) having on a major surface thereof a second impurity layer whose surface is mirror polished with a roughness of not more than 50 nm and which is of the same conductivity type as said first impurity layer, such that no foreign substances interfere with their contact; and

annealing said first and second semiconductor substrates (11, 13), whose said mirror polished surfaces are in contact with each other, at a temperature of not less than 200° C so as to bond the mirror polished surfaces together and thereby form a base layer consisting of said first and second impurity layers.

2. A method according to Claim 1, characterized in that said base layer is a p-type base layer.

3. A method according to Claim 2, characterized in that said first semiconductor substrate is an n-type silicon substrate (11) which serves as a high resistance n-type base layer and said first impurity layer is a first p-type layer (12) formed on the major surface of said n-type silicon substrate (11) and constituting a portion of said p-type base layer.

4. A method according to Claim 3, characterized in that said second semiconductor substrate is a p-type silicon substrate (13) with a uniform impurity concentration constituting the remaining portion of said p-type base layer.

5. A method according to Claim 3, characterized in that said second semiconductor substrate is a high resistance p-type silicon substrate (23) and said second impurity layer is a second p-type layer (24) formed on the major surface of said p-type silicon substrate (23) and constituting the remaining portion of said p-type base layer.

6. A method according to Claim 3, characterized in that said second semiconductor substrate is a second n-type silicon substrate and said second impurity layer is a second p-type layer formed on the major surface of said second n-type silicon substrate and constituting the remaining portion of said p-type base layer.

7. A method according to Claim 4, characterized in that one or more first p-type regions (33) having a higher impurity concentration than that of said first p-type layer (32) are selectively formed on the junction surface of said first p-type layer (32), second p-type regions (35) having a higher impurity concentration than that of said p-type silicon substrate (34) are formed at positions of said p-type silicon substrate (34) corresponding to said first p-type regions (33) formed on the major surface, and said first and second p-type regions (33, 35) constitute a gate region.

8. A method according to Claim 5, characterized in that the impurity concentration of said first p-type layer (22) is lower than that of said second p-type layer (24).

9. A method according to Claim 5, characterized in that the impurity concentration of said first p-type layer (22) is substantially equal to that of said second p-type layer (24).

10. A method according to Claim 5, characterized in that the impurity concentration of said first p-type layer (22) is higher than that of said second p-type layer (24).

11. A method according to Claim 1, characterized in that said base layer is a low resistance n-type base layer.

12. A method according to Claim 11, characterized in that said first semiconductor substrate is a first n-type silicon substrate (51) forming a high resistance n-type base layer, said first impurity layer is a first n-type layer (52) formed on the major surface of said first n-type silicon substrate (51) and constituting a portion of said low resistance n-type base layer, said second semiconductor substrate is a second n-type silicon substrate (53), and said second impurity layer is a second n-type layer (54) formed on the major surface of said second n-type silicon substrate (53) and constituting the remaining portion of said low resistance n-type base layer.

13. A method according to Claim 1, further comprising the step of polishing that surface of said second semiconductor substrate opposite the major surface thereof so as to decrease its thickness.

14. A method according to Claim 1, characterized in that the adopted optical polishing method is a mirror polishing method.

15. A method according to Claim 1, characterized in that the mirror polished surface is washed with at least one washing solution selected from the group consisting of water, a surfactant, an organic solvent, and an acid solution.

16. A method according to Claim 1, characterized in that the pure atmosphere contains foreign substances at a level of not more than 20

particles/m$^3$.

17. A method according to Claim 1, characterized in that the annealing temperature falls within the range of 600 to 1200$^°$C.

**Revendications**

1. Un procédé de fabrication d'un thyristor avec une couche de base comprenant une première et une deuxième couche d'impuretés, liées l'une à l'autre, comprenant les étapes suivantes:

mise en contact, dans une atmosphère virtuellement exempte de matières particulaires, d'un premier substrat semi-conducteur (11), comportant sur une surface principale une première couche d'impuretés (12), avec surface à poli miroir, d'une rugosité ne dépassant pas 50 nm, avec un deuxième substrat semi-conducteur (13) comportant sur une surface principale une deuxième couche d'impuretés, avec surface à poli miroir, d'une rugosité ne dépassant pas 50 nm et du même type de conductivité que ladite première couche d'impuretés, de sorte qu'il n'y a pas d'interférence de corps étrangers dans leur contact; et

recuit des dits premier et deuxième substrats semi-conducteurs (11, 13), dont lesdites surfaces à poli miroir sont en contact l'une avec l'autre, à une température non inférieure à 200$^°$C de façon à lier les surfaces à poli miroir et à former ainsi une couche de base composée des dites première et deuxième couches d'impuretés.

2. Un procédé selon la revendication 1, caractérisé en ce que ladite couche de base est une couche de base de type p.

3. Un procédé selon la revendication 2, caractérisé en ce que ledit premier substrat semi-conducteur est un substrat au silicium de type n (11), servant de couche de base de type n à résistance élevée et en ce que ladite première couche d'impuretés est une première couche de type p (12) formée sur la surface principale du dit substrat au silicium de type n (11) et constituant une partie de ladite couche de base de type p.

4. Un procédé selon la revendication 3, caractérisé en ce que ledit deuxième substrat semi-conducteur est un substrat au silicium de type p (13), avec une concentration uniforme en impuretés, constituant la partie restante de ladite couche de base de type p.

5. Un procédé selon la revendication 3, caractérisé en ce que ledit deuxième substrat semi-conducteur est un substrat au silicium de type p à résistance élevée (23) et en ce que ladite deuxième couche d'impuretés est une deuxième couche de type p (24) formée sur la surface principale du dit substrat au silicium de type p (23) et constituant la partie restante de ladite couche de base de type p.

6. Un procédé selon la revendication 3, caractérisé en ce que ledit deuxième substrat semi-conducteur est un deuxième substrat au silicium de type n et en ce que ladite deuxième couche d'impuretés est une deuxième couche de type p, formée sur la surface principale du dit deuxième substrat au silicium de type n et constituant la partie restante de ladite couche de base de type p.

7. Un procédé selon la revendication 4, caractérisé en ce que une ou plusieurs premières régions de type p (33), ayant une concentration plus élevée en impuretés que celle de ladite première couche de type p (32) sont formées sélectivement sur la surface de jonction de ladite première couche de type p (32), en ce que des deuxièmes régions de type p (35) ayant une concentration en impuretés plus élevée que celle du dit substrat au silicium de type p (34) sont formées en des points du dit substrat au silicium de type p (34) correspondant aux dites premières régions de type p (33) formées sur la surface principale, lesdites premières et deuxièmes régions de type p (33, 35) constituant une région de grille.

8. Un procédé selon la revendication 5, caractérisé en ce que la concentration en impuretés de ladite première couche de type p (22) est inférieure à celle de ladite deuxième couche de type p (24).

9. Un procédé selon la revendication 5, caractérisé en ce que la concentration en impuretés de ladite première couche de type p (22) est pratiquement égale à celle de ladite deuxième couche de type p (24).

10. Un procédé selon la revendication 5, caractérisé en ce que la concentration en impuretés de ladite première couche de type p (22) est plus élevée que celle de ladite deuxième couche de type p (24).

11. Un procédé selon la revendication 1, caractérisé en ce que ladite couche de base est une couche de base de type n à faible résistance.

12. Un procédé selon la revendication 11, caractérisé en ce que ledit premier substrat semiconducteur est un premier substrat au silicium de type n (51), formant une couche de base de type n à résistance élevée, ladite première couche d'impuretés étant une première couche de type n (52), formée sur la surface principale du dit premier substrat au silicium de type n (51) et constituant une partie de ladite couche de base de type n à faible résistance, et en ce que ledit deuxième substrat semi-conducteur est un deuxième substrat au silicium de type n (53), ladite deuxième couche d'impuretés étant une deuxième couche de type n (54), formée sur la surface principale du dit deuxième substrat au silicium de type n (53) et constituant la partie restante de ladite couche de base de type n à faible résistance.

13. Un procédé selon la revendication 1, comprenant en outre l'étape de polissage de la surface du dit deuxième substrat semi-conducteur qui est opposée à la surface principale de celui-ci, de façon à en réduire l'épaisseur.

14. Un procédé selon la revendication 1, caractérisé en ce que le procédé de polissage optique adopté est un procédé de polissage à poli miroir.

15. Un procédé selon la revendication 1, caractérisé en ce que la surface à poli miroir est lavée avec au moins une solution de lavage sélectionnée dans le groupe comprenant l'eau, un agent tensio-actif, un solvant organique et une solution acide.

16. Un procédé selon la revendication 1, caractérisé en ce que l'atmosphère pure contient des corps étrangers dont le niveau ne dépasse pas 20 particules/m$^3$.

17. Un procédé selon la revendication 1, caractérisé en ce que la température de recuit est comprise entre 600 et 1200°C.

**Patentansprüche**

1. Verfahren zum Herstellen eines Thyristors mit einer Basisschicht aus ersten und zweiten Fremdatom- oder Dotierungsschichten, die miteinander verbunden sind, umfassend die folgenden Schritte:
in einer von Teilchenstoffen bzw. Partikeln praktisch freien Atmosphäre erfolgendes Inberührungbringen eines ersten Halbleitersubstrats (11), das auf einer ersten Hauptfläche desselben eine ersten Fremdatom- oder Dotierungsschicht (12) aufweist, deren Oberfläche mit einer Rauhigkeit von nicht mehr als 50 nm hochglanzpoliert ist, mit einem zweiten Halbleitersubstrat (13), das auf einer Hauptfläche desselben eine zweite Fremdatom- oder Dotierungsschicht aufweist, deren Oberfläche mit einer Rauhigkeit von nicht mehr als 50 nm hochglanzpoliert ist und welche den gleichen Leitungstyp wie die erste Dotierungsschicht aufweist, derart, daß keine Fremdsubstanzen ihre(n) Berührung oder Kontakt stören, und Glühen der ersten und zweiten Halbleitersubstrate (11, 13), deren hochglanzpolierte Flächen miteinander in Berührung bzw. Kontakt stehen, bei einer Temperatur nicht unter 200°C, um dabei die hochglanzpolierten Flächen miteinander zu verbinden und damit eine aus erster und zweiter Dotierungsschicht bestehende Basisschicht auszubilden.

2. Verfahren nach Anspruch 1, dadurch gekennzeichnet, daß die Basisschicht eine p-Typ-Basisschicht ist.

3. Verfahren nach Anspruch 2, dadurch gekennzeichnet, daß das erste Halbleitersubstrat ein n-Typ-Siliziumsubstrat (11) ist, das als hochohmige n-Typ-Basisschicht dient, und die erste Dotierungsschicht eine auf der Hauptfläche des n-Typ-Siliziumsubstrats (11) geformte erste p-Typ-Schicht (12) ist, die einen Abschnitt der p-Typ-Basisschicht bildet.

4. Verfahren nach Anspruch 3, dadurch gekennzeichnet, daß das zweite Halbleitersubstrat ein p-Typ-Halbleitersubstrat (13) mit gleichmäßiger Fremdatomkonzentration ist, welches den restlichen Abschnitt der p-Typ-Basisschicht bildet.

5. Verfahren nach Anspruch 3, dadurch gekennzeichnet, daß das zweite Halbleitersubstrat ein hochohmiges p-Typ-Siliziumsubstrat (23) ist und die zweite Dotierungsschicht eine auf der Hauptfläche des p-Typ-Siliziumsubstrats geformte zweite p-Typ-Schicht (24) ist, welche den restlichen Abschnitt der p-Typ-Basisschicht bildet.

6. Verfahren nach Anspruch 3, dadurch gekennzeichnet, daß das zweite Halbleitersubstrat ein zweites n-Typ-Siliziumsubstrat ist und die zweite Dotierungsschicht eine auf der Hauptfläche des zweiten n-Typ-Siliziumsubstrats geformte und den restlichen Abschnitt der p-Typ-Basisschicht bildende zweite p-Typ-Schicht ist.

7. Verfahren nach Anspruch 4, dadurch gekennzeichnet, daß eine oder mehrere erste p-Typ-Bereiche bzw. -zonen (33) einer höheren Fremdatomkonzentration als diejenige der ersten p-Typ-Schicht (32) selektiv auf der Übergangsfläche der ersten p-Typ-Schicht (32) geformt werden, zweite p-Typ-Zonen (35) einer höheren Fremdatomkonzentration als diejenige des p-Typ-Siliziumsubstrats (34) an Stellen des p-Typ-Siliziumsubstrats (34), welche den auf der Hauptfläche geformten ersten p-Typ-Zonen (33) entsprechen, geformt werden und die ersten und zweiten p-Typ-Zonen (33, 35) eine Gatezone bilden.

8. Verfahren nach Anspruch 5, dadurch gekennzeichnet, daß die Fremdatomkonzentration der ersten p-Typ-Schicht (22) niedriger ist als die der zweiten p-Typ-Schicht (24).

9. Verfahren nach Anspruch 5, dadurch gekennzeichnet, daß die Fremdatomkonzentration der ersten p-Typ-Schicht (22) derjenigen der zweiten p-Typ-Schicht (24) im wesentlichen gleich ist.

10. Verfahren nach Anspruch 5, dadurch gekennzeichnet, daß die Fremdatomkonzentration der ersten p-Typ-Schicht (22) höher ist als die der zweiten p-Typ-Schicht (24).

11. Verfahren nach Anspruch 1, dadurch gekennzeichnet, daß die Basisschicht eine niederohmige n-Typ-Basisschicht ist.

12. Verfahren nach Anspruch 11, dadurch gekennzeichnet, daß das erste Halbleitersubstrat ein erstes n-Typ-Siliziumsubstrat (51) ist, das eine hochohmige n-Typ-Basisschicht bildet, die erste Dotierungsschicht eine auf der Hauptfläche des ersten n-Typ-Siliziumsubstrats (51) geformte und einen Abschnitt der niedrigohmigen n-Typ-Basisschicht bildende erste n-Typ-Schicht (52) ist, das zweite Halbleitersubstrat ein zweites n-Typ-Siliziumsubstrat (53) ist und die zweite Dotierungsschicht eine auf der Hauptfläche des zweiten n-Typ-Siliziumsubstrats (53) geformte und den restlichen Abschnitt der niedrigohmigen n-Typ-Basisschicht bildende zweite n-Typ-Schicht (54) ist.

13. Verfahren nach Anspruch 1, ferner umfassend den Schritt eines Polierens der Fläche des zweiten Halbleitersubstrats, welche dessen Hauptfläche gegenüberliegt, zwecks Verkleinerung der Dicke desselben.

14. Verfahren nach Anspruch 1, dadurch gekennzeichnet, daß die angewandte optische Poliermethode eine Hochglanzpoliermethode ist.

15. Verfahren nach Anspruch 1, dadurch gekennzeichnet, daß die hochglanzpolierte Fläche mit mindestens einer Waschlösung aus der Wasser, ein oberflächenaktives Mittel bzw. Netzmittel, ein organisches Lösungsmittel und eine Säurelösung umfassenden Gruppe gewaschen wird.

16. Verfahren nach Anspruch 1, dadurch gekennzeichnet, daß die Reinluftatmosphäre Fremdsubstanzen in einer Menge von nicht mehr als 20 Teilchen/m$^3$ enthält.

17. Verfahren nach Anspruch 1, dadurch gekennzeichnet, daß die Glühtemperatur im Bereich von 600 - 1200 $^\circ$C liegt.

F I G. 1A

p     13

p     12

$n^-$     11

F I G. 1B

p     13

14

12

$n^-$     11

F I G. 1C

15

$n^-$     13

14

p     12

$n^-$     11

$p^+$     16

# F I G. 1D

# F I G. 2B

# F I G. 2A

# F I G. 3

# F I G. 4

F I G. 5A

F I G. 5B

F I G. 5C

# F I G. 6

# F I G. 7

# F I G. 8

# F I G. 9

F I G. 10A

F I G. 10B

F I G. 10C

# F I G. 11

# F I G. 12

# F I G. 13

F I G. 14A

F I G. 14B

21

# F I G. 15

# F I G. 16